# EUROPEAN PATENT SPECIFICATION

(11) **EP 0 638 952 B1**
(45) Date of publication and mention of the grant of the patent: **05.06.2002**
(21) Application number: 94305823.0
(22) Date of filing: 05.08.1994
(51) Int. Cl.: H01M 10/48, G01R 22/02

(54) **Battery with state-of-charge indicator**
Batterie mit Ladezustandanzeigevorrichtung
Batterie à indicateur d'état de charge

(30) Priority: 09.08.1993 US 103019
(43) Date of publication of application: 15.02.1995
(73) Proprietor: EVEREADY BATTERY COMPANY, INC., St. Louis Missouri 63164 (US)
(72) Inventor: Bailey, John C., Columbia Station, Ohio 44028 (US)
(74) Representative: Lord, Hilton David

(56) References cited:
- EP-A- 0 495 636
- WO-A-93/06474
- DE-A- 3 331 360
- GB-A- 2 157 066
- US-A- 3 708 729
- US-A- 4 693 119
- PATENT ABSTRACTS OF JAPAN vol. 7, no. 111 (E-175) <1256> 14 May 1983 & JP 58 032 376 A (CANON K.K.)
- DATABASE WPI Derwent Publications Ltd., London, GB; AN 76-51366X MATSUSHITA & JP-B-51 018 061 (MATSUSHITA ELEC IND KK)
- DATABASE WPI Derwent Publications Ltd., London, GB; AN 74-79986V SANYO ELECTRIC CO & JP-B-56 029 348 (SANYO)

## Description

The present invention relates to a battery containing a coulometric charge indicator device which is capable of displaying the capacity of the battery during and as a result of discharge.

Batteries are generally stored for various periods of time before being put into use. Typically, the batteries are stored by the seller and they are then frequently stored again by the purchaser before being put to use. In view of the fact that the batteries could be stored for long periods of time before finally being used, it would be desirable to have some form of testing means in order to determine if a stored battery, for example, has been partially discharged and thus may not have sufficient charge remaining to operate a desired device.

Battery testers have been developed to measure the strength remaining in the battery. However, the first such devices were completely separate from the battery itself. More recently battery testers which are either included in the battery package or form part of the label secured to the battery have been proposed. Such testers generally indicate the capacity remaining in the battery.

U.S. Patent No. 4,702,564 discloses a device for testing a battery, particularly a small, portable battery, comprising a flexible, transparent substrate on which is deposited a narrow band of a black light-absorbing material. A conductive material, which may taper outwardly in opposite directions from a central point to a pair of outer terminals, is then deposited on top of the substrate, either on the same side of the substrate as the light-absorbing layer or on the side of the substrate opposite that containing the light-absorbing layer. A layer of a cholesteric liquid crystal material is then deposited on the substrate, either on the opposite side from the light-absorbing layer or over the absorbing layer. The conductive material is an epoxy cement-based conductor, preferably silver, printed or painted directly on the substrate. An indicator scale is located along sections of the conductive material.

In order to test a dry cell battery using this device, the terminal ends of the conductive material are placed in contact with the battery terminals, causing a current to flow. This heats the conductive material, the heat generated being the most intense at the central point and radiating outwardly. The heat is transferred through the thin substrate to the liquid crystal layer which results in a colour change in the liquid crystal. The traverse of the colour change along the length of the indicator scale, outwardly from the centre point, is proportional to the current or voltage output or the condition of the battery to be tested and can be read on the indicator scale which is calibrated accordingly. The tester also includes means for determining the amp-hours or life of a battery.

U.S. Patent No. 5,015,544 discloses a battery strength indicating and switch means on a battery which is coupled across the terminals of the battery. In addition, the battery strength indicating means is also provided with an in-line switch which can easily be depressed to complete the circuit so as to place the indicator means across the terminals of the cell and display the charge of the battery.

U.S. Patent No. 5,059,895 discloses a battery voltmeter comprising:
(A) a dielectric layer;
(B) a conductive layer above or below one of the surfaces of the dielectric layer; and
(C) a temperature sensitive colour indicator layer in thermal contact with the conductive layer,
characterised in that the conductive layer has (i) thermal insulating means under one of its surfaces and (ii) sufficient heat generating capacity to affect a change in the temperature sensitive colour indicator layer. The voltmeter can be integrated into a label and attached directly to a battery.

U.S. Patent No. 4,835,475 discloses an apparatus for indicating the electromotive force of a dry battery which comprises:
(i) a film base;
(ii) an electrically conductive layer disposed on one side of the film base;
(iii) a protective layer disposed on the electrically conductive layer, and
(iv) a thermochromic layer disposed on the other side of the film base.

Japanese Kokai Patent, Sho 63-213256 discloses a battery equipped with a colour timer in which a sensor that changes colour with time is placed on a battery so that the capacity consumed can be displayed.

WO-A-93/06474 discloses an electrochemical cell having a state-of-charge indicator, which employs an indicator cell connected in parallel configuration with the main cell so as to indicate the main cell discharge potential.

Other types of label charge indicating devices have been disclosed in the art.

In the NASA Technical Note NASA TN D-5773, National Aeronautics and Space Administration, Washington, D.C. July 1970, an article by Richard S. Secunde and Arthur G. Birchenough discloses a mercury electrochemical coulomer as a battery charge indicator. Specifically, use of a mercury-column electrochemical coulometer is discussed as a means of indicating the state of charge of secondary batteries. A state-of-charge indicator was designed, built in breadboard form, and tested. The coulometer is the element which integrates the ampere-hours into and out of the battery. The state of charge then is the difference between the known fully charged battery capacity and the net ampere-hours removed. The general non linear charge-discharge characteristics of a battery were matched through the use of operational-amplifier techniques. The results of electrical and temperature tests on the breadboard of the indicator demonstrate that the mercury-column coulometer is a feasible device around which a battery state-of-charge indicator suitable for space power systems, or other uses, might be built.

JP-A-51018061 discloses a remaining charge indicator device for a multiple cell battery, comprising a mercury glass tube coulometer in series with an electric charge memory cell, connected in parallel with a shunt resistance placed across the battery terminals.

Although the prior art does provide some examples of state-of-charge devices for electrochemical cells, there remains a growing need for further, improved, charge indicators which are cost effective to produce, easily incorporated in the battery package and preferably in the battery label and which are reliable for the consumer to use.

The present invention addresses the problems known to be associated with the prior art devices and provides a state-of-charge indicator which satisfies the requirements outlined above.

Accordingly, the present invention provides, in its first aspect, an electrochemical cell containing a coulometric charge indicator device which is connected in parallel across a current path of a resistive segment of the cell and which enables a determination of the capacity of the cell resulting from discharge, wherein the indicator device is in the form of a thin film and is located on the cell.

In a particular embodiment of this aspect of the invention, there is provided an electrochemical cell housed in a container and having a coulometric charge indicator device, said coulometric charge indicator device comprising a first electrode capable of being electrochemically dissolved, an electrolyte disposed in contact with said first electrode and a second electrode in contact with said electrolyte and being capable of receiving the dissolved first electrode; said coulometric charge indicator device connected in parallel across a current path of a resistive segment of said cell so that when the cell is discharged a current will flow through the resistive segment thereby providing a voltage across the coulometric charge indicator device so that said first electrode will dissolve and be transported through the electrolyte and deposited on the second electrode where the amount of the first electrode deposited on the second electrode can be used to indicate the capacity of the battery, wherein the indicator device is in the form of a thin film and is located on the cell.

As used herein the term "deposited on" the second electrode also includes those cases where the first electrode will at least be partially absorbed into the second electrode.

The present invention is further illustrated by reference to the following drawings, in which:
Figure 1 is a perspective view of a thin film coulometric charge indicator device in accordance with this invention;
Figure 2 is a perspective view of another thin film coulometric charge indicator device in accordance with this invention employing an electrolyte of variable thickness;
Figure 3 is a perspective of another thin film coulometric charge indicator device in accordance with this invention employing an electrolyte with a stepped construction;
Figure 4 is a perspective view of another thin film coulometric charge indicator device in accordance with this invention;
Figure 5 is a perspective view of an in-plane construction of a thin film coulometric charge indicator device in accordance with this invention; and
Figure 6 is a schematic view of the circuitry for a thin film coulometric charge indicator device in accordance with this invention assembled on a cell coupled to a load.

A coulometer is an electrolyte cell used for the measurement of the quantity of electricity passing through a circuit. A conventional type of coulometer generally uses copper electrodes in a bath of copper sulphate. When a voltage is applied across the electrodes, the copper will dissolve from one electrode and will be deposited on or absorbed into the other electrode. The amount of deposited/absorbed copper is generally proportional to the quantity of electricity in coulombs passing through the circuit. If such a copper arrangement is used for the state-of-charge indicator device of the present invention, the amount of copper deposited/absorbed may be used to indicate the capacity of the cell.

There are various types of coulometer available but not all of these are suitable for use in the device of the present invention. Thus, mercury coulometers use a liquid electrolyte and metallic mercury both of which make the system difficult to manufacture and unsuitable for use in a consumer product. Thin gold/solid electrolyte/silver coulometers are also not suitable for battery state-of-charge indicators because they cannot be read visually and generally can only be read at their full capacity.

A coulometer is typically connected in series such that all of the current being measured must pass through the coulometer. However, when a coulometer is to be used in a battery, for example as a state-of-charge indicator, the coulometer must be capable of passing the high currents which can be delivered by a cell, yet must cause only a negligible voltage drop. Ideally, the coulometer should have a lower impedance than the cell. However, a low impedance coulometer which is capable of carrying the large currents delivered by a cell would probably require large electrode areas. These requirements are contrary to the desire to make a small inexpensive state-of-charge monitoring device which can be attached to or form part of a cell, for example, a part of the cell label. The device of the present invention addresses these issues and includes a coulometer which takes these points into account and which can be incorporated with ease and little expense into the label of a battery.

In the device of the present invention, we use a thin film coulometer construction. The coulometer is connected in parallel across a current path of a resistive segment of the cell and, in this way, only a small amount of the current will be drawn by the coulometer. The resistive area is any resistive segment of the cell through which current will pass when the cell is being discharged. The precise thickness of the coulometer is not essential to the present invention, provided that it can be incorporated with ease into the battery package/label and provided that it fulfills the requirements discussed herein. The thickness may, for example, be dependent on the type of coulometer construction. Typically, however, we have found that the coulometer film should be no more than 0.020 inches (say 0.5 mm) thick, preferably no more than 0.005 inches (say 0.127 mm) thick and most preferebly no more than 0.003 inches (say 0.0762 mm) thick.

In the present invention, a thin film coulometer construction is located on the cell and positioned so as to be connected in parallel across a current path of a resistive segment of the cell. When the cell is discharged, therefore, a voltage will be applied across the coulometric charge indicator device. Since the coulometer is driven by the voltage drop across the discharge circuit of the resistance segment of the cell, only a small part of the current flows through the coulometer.

The precise configuration of the coulometer is not essential to the present invention and any configuration known in the art can equally be applied here, so long as the requirements discussed herein are fulfilled. Thus, the coulometer may be configured as either a parallel plate construction or as spaced-apart plates in a common plane. A switch is not required in either of these cases. As discussed above, the thickness of the coulometer film may be dependent on the configuration of the coulometer. We generally prefer that, when the coulometer is in an in-plane configuration, the thickness of the coulometer is at the lower end of the range.

The capacity removed from the cell can be determined, in the case of a copper coulometer, by observing the deposit/absorption of the copper on a parallel plate construction or by observing the position of the electrolyte in an in-plane plate construction. In each construction, a suitable readout scale could be used so as to simplify the determination of remaining capacity. The coulometer can display the remaining capacity of the cell from actual discharge of the cell but will not show capacity loss from corrosion or any non-discharge means.

As discussed above, the coulometer is driven by the small voltage drop across the cell's resistive segment. Preferably the voltage drop across the resistive segment may be about 0.2 volts or lower and more preferably about 0.01 volt or lower. For most applications, the resistive segment should be a fraction of the intended cell load. For example, in a cell used on a 150-ohm drain, a resistive segment of 0.04 ohm would be suitable for a 3.9-ohm high rate discharge. Generally, a resistive segment of 0.01 to 1000 ohms would be suitable for most applications.

Generally, the voltage drop across the resistive segment should be approximately 4% of the voltage of the cell or lower. Preferably, the anodic and cathodic reactions of the coulometer should be of equal electrochemical potential and have low overpotentials. A thin film coulometer is ideal for this application.

The state-of-charge coulometer of the present invention typically contains two electrodes. Suitable materials for the first electrode of the coulometer of this invention include copper, nickel, silver bismuth, tin, zinc and gold, of which copper is the most preferred.

The choice of electrolyte for use in the coulometer is not essential to the present invention and the choice is typically based on factors normally taken into account when assembling coulometers. Suitable electrolytes for the arrangement of the present invention include aqueous solutions of gels containing soluble salts such as nitrates, sulphates or halides of the electrode material and solid electrolytes such as ionically conductive polymers, solid state inorganic materials and organic-inorganic composites. Of these, the polymeric electrolytes are the most preferred. The polymeric electrolytes may include water or lower molecular weight plasticizers such as organic solvents. Examples of polymeric resins suitable for electrolyte manufacture include polyvinyl alcohol, polyethylene oxide, polymerised hydroxyethyl cellulose and poly(2-acrylamido-2-methyl-1-propane sulfonic acid). In some applications, a supporting electrolyte may be used. Polyethylene oxide containing copper ions such as copper sulphate, and silver nitrate plus PEO (polyethylene oxide) are the preferred electrolytes for this invention.

The electrolyte may be included in the coulometer arrangement in a variety of forms. Thus, the electrolyte may be disposed in a space defined by the first and second electrodes being spaced apart in the same plane. The electrolyte may also be used with a uniform or varied thickness or, alternatively, with a stepped thickness. When an electrolyte of variable thickness is used, the rate of dissolution of, for example, a copper electrode, and the resulting deposition of copper on the second electrode will be faster at the thinner portions of the coulometer. In an alternative arrangement with an electrode of stepped thickness, a more accurate determination of the amount of charge passed can be made, since the rate of deposition of, for example, copper, will be inversely proportional to the electrolyte thickness.

The second electrode is preferably a transparent or translucent electrode, such that the deposition of material from the first electrode can be observed visually. In an in-plane construction, the second electrode need not be transparent or translucent since the movement of the electrolyte between the electrodes can be used to indicate the capacity of the cell. The choice of materials for the second electrode is within the skill of the man in the art and it may be, for example, that the same material is used for both the first and second electrodes.

The preferred coulometer for use in the present invention employs a copper foil as the first electrode, an ionically conductive polymer electrolyte, such as polyethylene oxide containing copper ions, and a second electrode of indium tin oxide.

The present invention will now be described with reference to the accompanying drawings.

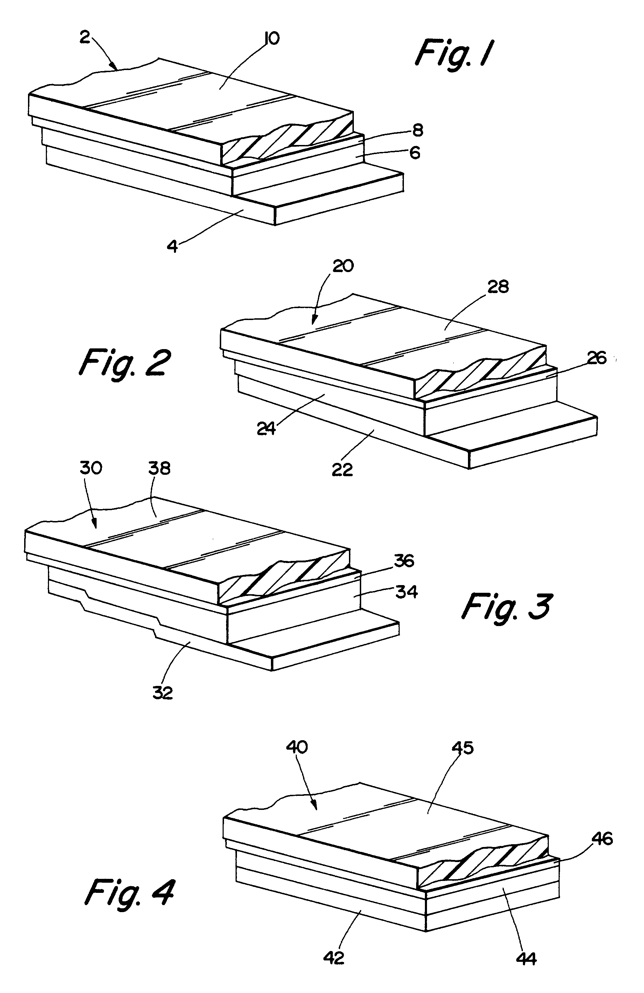

In Figure 1, a thin film coulometric charge indicator device 2 is shown comprising an electrode 4 of copper foil or a printed copper ink, a polymer electrolyte 6, an optically transparent electrode 8 and a top layer of plastic film 10. The top layer of plastic film 10 could be the label for the cell so that the coulometer 2 would be connected in parallel across a resistive segment of the cell, such as a copper foil section, a silver printed layer or a component of the cell such as a tab or connector. Upon being discharged, the current through the resistive segment of the cell would put a voltage across the coulometer 2 which will cause the copper electrode 4 to dissolve, be transported through the electrolyte 6 and be deposited on the optically transparent electrode 8. The amount of copper deposited on optically transparent electrode 8 can then be used to indicate the capacity of the cell.

Figure 2 shows a similar type coulometer 20 comprising an electrode 22 of copper foil or printed copper ink, electrolyte 24, optically transparent electrode 26 and top plastic film 28. The electrolyte 24 is constructed with a variable thickness so that the rate of dissolution of copper electrode 22 and deposition of copper on electrode 26 is faster at the thinner portions of the coulometer. This effect can be achieved by printing the electrolyte layers in different thicknesses or by embossing the copper foil. The embossed areas of the electrode will provide one or more cavities so that the electrolyte layer will be thicker in such cavities. This feature can be used to produce an appropriate predesigned indicia such as a digital or alphanumeric display, e.g., a message regarding the state of cell discharge could be provided by the remaining undissolved portions of electrode 22.

Figure 3 shows a similar type coulometer 30 comprising copper foil electrode 32, electrolyte 34, optically transparent electrode 36 and top plastic film 38. The electrolyte 34 is constructed with a stepped thickness so that a more accurate determination of the amount of charge passed can be made since the rate of copper deposition will be inversely proportional to the electrolyte thickness. Alternatively, electrode 32 could be provided in different thicknesses, conveniently by printing a copper ink, such that the thicker portions spell out a message to the consumer, which thicker portions are readily visible as the surrounding thinner areas are consumed by dissolution.

Figure 4 shows a coulometer 40 comprising a printed conductive ink electrode layer 42, such as copper, silver, carbon or the like, a printed polymer electrolyte 44, a sputtered or vapour deposited copper electrode layer 46 and top plastic layer 48. When a voltage is placed across coulometer 40, the copper layer 46 will dissolve and be deposited on an electrode layer 42. By observing the disappearance of copper layer 46, the amount of discharge of the cell can be judged from the colour of layer 46. This visual change can be enhanced by providing electrolyte 44 with a contrasting colour through the use of a dye or pigment. Additionally, copper layer 46 could conceal a suitable message to the consumer contained in or on the electrolyte layer or counter electrode layer, which message becomes visible as the electrode layer 46 is dissolved.

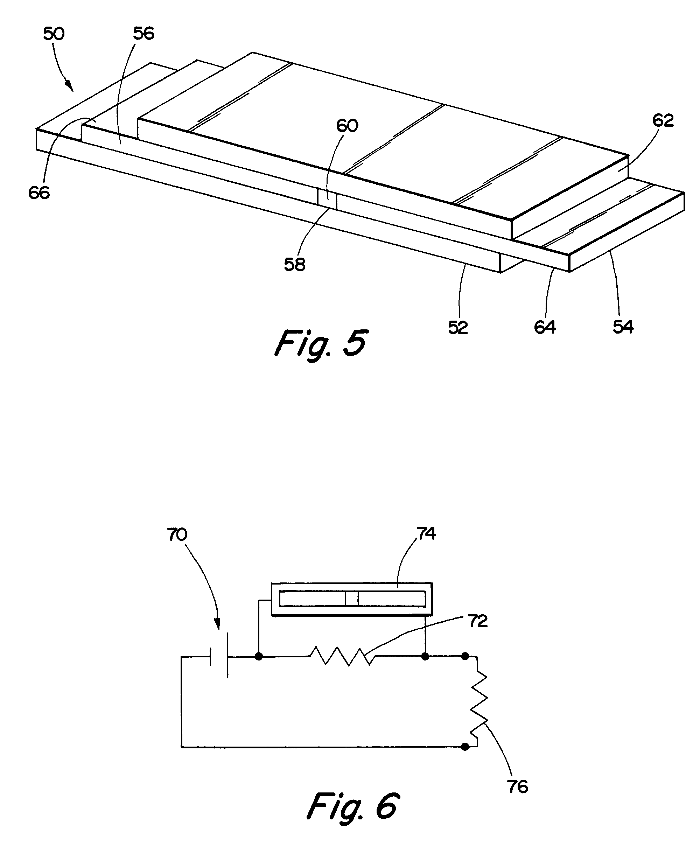

Figure 5 shows a coulometer 50 comprising a plastic substrate 52, electrode 54 spaced apart from and in line with electrode 56 and having an electrolyte 58 disposed in the space 60 defined by the spaced apart electrodes 54 and 56. Preferably, the electrodes 54 and 56 are made of copper. A protective insulating layer 62 is placed on top of electrodes 54 and 56 so that with plastic substrate 52, the electrolyte 58 is confined to the space 60 between electrodes 54 and 56. Area 64 of electrode 54 can be electronically connected to one end of a resistance segment on the cell while area 66 or electrode 56 can be electronically connected to the opposite end of the resistive segment on the cell. In this embodiment, copper ions are stripped from one electrode and carried to the opposite electrode by the narrow width electrolyte and thus the position of the electrolyte can be observed and used to indicate the capacity of the cell.

Figure 6 is a schematic circuit including a cell 70 having positive and negative electrodes and a resistive area 72 (shunt resistance). The resistive area is any resistive segment of the cell through which current will pass when the cell is being discharged. Connected in parallel across resistive area 72 is coulometer 74 of the type shown in Figure 5 using copper electrodes. Connected across the cell 70 is a resistive segment 72 and places a voltage across coulometer 74. Copper from one electrode will dissolve and be deposited on the other electrode thereby moving the electrolyte as discussed with reference to figure 5. The new location of the electrolyte can then be used to indicate the capacity of the cell. As stated above, a suitable readout scale can be used in conjunction with the coulometers of this invention to provide a visual readout of the capacity of the cell.

It will be understood that various changes in the details, materials and arrangements of parts of the coulometer which have been described herein may be made by those skilled in the art within the principle and scope of the inventions as expressed in the claims.

## Claims

1. An electrochemical cell containing a coulometric charge indicator device (2) which is connected in parallel across a current path of a resistive segment of the cell and which enables a determination of the capacity of the cell resulting from discharge, **characterised in that** the indicator device is in the form of a thin film and is located on the cell.

2. The electrochemical cell of claim 1 wherein the coulometric charge indicator device is no more than 0.020 inches (say 0.5mm) in thickness.

3. The electrochemical cell of claim 2 wherein the coulometric charge indictor device is no more than 0.005 inches (say 0.127 mm) in thickness.

4. The electrochemical cell of any one of claims 1 to 3 wherein the resistive segment is from about 0.01 to 1000 ohms.

5. The electrochemical cell of claim 1 wherein the coulometer includes a first electrode (4), a second electrode (8) and an electrolyte (6) and wherein the second electrode (8) is superimposed over the electrolyte (6) and first electrode (4).

6. The electrochemical cell of claim 5 wherein the first and second electrodes (4,8) are spaced apart in the same plane and the electrolyte (6) is disposed in the space defined by the first electrode (4) and second electrode (8).

7. The electrochemical cell of claim 5 or claim 6 wherein the electrolyte (6) has variable thickness construction (24).

8. The electrochemical cell of claim 5 or claim 6 wherein the electrolyte (6) has a stepped-shape construction (34).

9. The electrochemical cell of claim 7 wherein the variable thickness of the electrolyte (6) is designed such that upon discharge a predesigned indicia is produced on the coulometric charge indicator device (2).

10. The electrochemical cell of claim 5 wherein the first electrode (4) is embossed to provide at least one cavity so that the electrolyte (6) in said at least one cavity will be thicker than the electrolyte (6) disposed adjacent the cavity so that upon discharge, a predesigned indicia is produced on the coulometric charge indicator device (2).

11. The electrochemical cell of any one of claims 5 to 10 wherein the first electrode (4) is selected from copper, nickel, silver, bismuth, tin, zinc and gold and the second electrode (8) is selected from copper, nickel, silver, bismuth, tin, zinc and gold.

12. The electrochemical cell of any one of claims 5 to 11 wherein the electrolyte (6) is selected from the group consisting of ionically conductive polymers, solid state inorganic materials and organic-inorganic composites.

13. The electrochemical cell of any one of claims 5 to 12 wherein the first electrode (4) is copper, the second electrode (8) is copper, and the electrolyte (6) is polyethylene oxide containing copper ions.

14. The electrochemical cell of any one of claims 5 to 12 wherein the first electrode (4) is silver, the second electrode (8) is silver and the electrolyte (6) comprises silver nitrate.

15. The electrochemical cell of any one of the preceding claims wherein a plastic film (10) is disposed over the coulometer (2) and wherein said plastic film (10) functions as the label for the cell.

16. The electrochemical cell of any one of the preceding claims wherein a readout scale is used with the coulometer (2) so that the remaining capacity of the cell can be definitely observed during cell discharge.

17. An electrochemical cell housed in a container and having a coulometric charge indicator device (2), said coulometric charge indicator device (2) comprising a first electrode (4) capable of being electrochemically dissolved, an electrolyte (6) disposed in contact with said first electrode (4) and a second electrode (8) in contact with said electrolyte (6) and being capable of receiving the dissolved first electrode (4); said coulometric charge indicator device (2) connected in parallel across a current path of a resistive segment of said cell so that when the cell is being discharged a current will flow through the resistive element thereby providing a voltage across the coulometric charge indicator device (2) so that said first electrode (4) will dissolve and be transported through the electrolyte (6) and deposited on the second electrode (8) and wherein the amount of the first electrode (4) deposited on the second electrode (6) can be used to indicate the capacity of the cell, **characterised in that** the indicator device is in the form of a thin film and is located on the cell.

## Patentansprüche

1. Elektrochemische Zelle, die eine coulometrische Ladungsindikatorvorrichtung (2) enthält, die parallel zu einem Strompfad eines Widerstandssegments der Zelle angeschlossen ist, und die die Bestimmung der sich aus der Entladung ergebenden Kapazität der Zelle ermöglicht, **dadurch gekennzeichnet, daß** die Indikatorvorrichtung die Form eines dünnen Films hat und auf der Zelle angeordnet ist.

2. Elektrochemische Zelle von Anspruch 1, wobei die coulometrische Ladungsindikatorvorrichtung eine Dicke von nicht mehr als 0,020 Zoll (ungefähr 0,5 mm) hat.

3. Elektrochemische Zelle von Anspruch 2, wobei die coulometrische Ladungsindikatorvorrichtung eine Dicke von nicht mehr als 0,005 Zolle (ungefähr 0,127 mm) hat.

4. Elektrochemische Zelle von irgendeinem der Ansprüche 1 bis 3, wobei das Widerstandssegment einen Widerstand von 0,01 bis 1000 Ohm hat.

5. Elektrochemische Zelle von Anspruch 1, wobei das Coulometer eine erste Elektrode (4), eine zweite Elektrode (8) und einen Elektrolyten (6) umfaßt, und wobei die zweite Elektrode (8) über dem Elektrolyten (6) und der ersten Elektrode (4) angeordnet ist.

6. Elektrochemische Zelle von Anspruch 5, wobei die erste und zweite Elektrode (4, 8) in der gleichen Ebene in einem gewissen Abstand angeordnet sind, und der Elektrolyt (6) in dem durch die erste Elektrode (4) und die zweite Elektrode (8) definierten Zwischenraum angeordnet ist.

7. Elektrochemische Zelle von Anspruch 5 oder Anspruch 6, wobei der Elektrolyt (6) eine Bauweise (24) von variabler Dicke hat.

8. Elektrochemische Zelle von Anspruch 5 oder Anspruch 6, wobei der Elektrolyt (6) eine Bauweise (34) von abgestufter Form hat.

9. Elektrochemische Zelle von Anspruch 7, wobei die variable Dicke des Elektrolyten (6) so gewählt ist, daß bei der Entladung eine vorher festgelegte Kennzeichnung auf der coulometrischen Ladungsindikatorvorrichtung (2) erzeugt wird.

10. Elektrochemische Zelle von Anspruch 5, wobei die erste Elektrode (4) geprägt ist, um mindestens einen Hohlraum zu erhalten, so daß der Elektrolyt (6) in dem mindestens einen Hohlraum dicker als der Elektrolyt (6) in dem an den Hohlraum angrenzende Gebiet ist, so daß bei der Entladung eine vorher festgelegte Kennzeichnung auf der coulometrischen Ladungsindikatorvorrichtung (2) erzeugt wird.

11. Elektrochemische Zelle von irgendeinem der Ansprüche 5 bis 10, wobei die erste Elektrode (4) aus Kupfer, Nickel, Silber, Wismut, Zinn, Zink und Gold ausgewählt ist, und die zweite Elektrode (8) aus Kupfer, Nickel, Silber, Wismut, Zinn, Zink und Gold ausgewählt ist.

12. Elektrochemische Zelle von irgendeinem der Ansprüche 5 bis 11, wobei der Elektrolyt (6) aus der Gruppe ausgewählt ist, die aus ionisch leitenden Polymeren, festen anorganischen Materialien und organischen-anorganischen Verbundstoffen besteht.

13. Elektrochemische Zelle von irgendeinem der Ansprüche 5 bis 12, wobei die erste Elektrode (4) Kupfer ist, die zweite Elektrode (8) Kupfer ist, und der Elektrolyt (6) Polyäthylenoxid, das Kupferionen enthält, ist.

14. Elektrochemische Zelle von irgendeinem der Ansprüche 5 bis 12, wobei die erste Elektrode (4) Silber ist, die zweite Elektrode (8) Silber ist, und der Elektrolyt (6) Silbernitrat aufweist.

15. Elektrochemische Zelle von irgendeinem der vorhergehenden Ansprüche, wobei ein Kunststoff-Film (10) über dem Coulometer (2) angeordnet ist, und wobei der Kunststoff-Film (10) als Etikett für die Zelle dient.

16. Elektrochemische Zelle von irgendeinem der vorhergehenden Ansprüche, wobei eine Ableseskala mit dem Coulometer (2) verwendet wird, so daß die verbleibende Kapazität der Zelle während der Zellentladung eindeutig beobachtet werden kann.

17. Elektrochemische Zelle, die in einem Behälter untergebracht ist und eine coulometrische Ladungsindikatorvorrichtung (2) hat, wobei die coulometrische Ladungsindikatorvorrichtung (2) eine erste Elektrode (4) aufweist, die elektrochemisch aufgelöst werden kann, einen Elektrolyten (6) aufweist, der in Kontakt mit der ersten Elektrode (4) angeordnet ist, und eine zweite Elektrode (8) aufweist, die in Kontakt mit dem Elektrolyten (6) angeordnet ist und die aufgelöste erste Elektrode (4) aufnehmen kann; wobei die coulometrische Ladungsindikatorvorrichtung (2) parallel zu einem Strompfad eines Widerstandssegments der Zelle angeschlossen ist, so daß dann, wenn die Zelle entladen wird, ein Strom durch das Widerstandselement fließt, wodurch sich eine Spannung an der coulometrischen Ladungsindikatorvorrichtung (2) ergibt, so daß die erste Elektrode (4) sich auflöst und durch den Elektrolyten (6) befördert wird und auf der zweiten Elektrode (8) abgelagert wird, und wobei die auf der zweiten Elektrode (8) abgelagerte Menge der ersten Elektrode (4) verwendet werden kann, um die Kapazität der Zelle anzuzeigen, **dadurch gekennzeichnet, daß** die Indikatorvorrichtung die Form eines dünnen Films hat und auf der Zelle angeordnet ist.

## Revendications

1. Pile électrochimique contenant un dispositif indicateur de charge coulométrique (2) qui est relié en parallèle d'un côté et de l'autre d'un trajet de circulation de courant d'un segment résistif de la pile et qui permet une détermination de la capacité de la pile résultant de la décharge, **caractérisée en ce que** le dispositif indicateur est sous la forme d'une couche mince et est situé sur la pile.

2. Pile électrochimique selon la revendication 1, dans laquelle le dispositif indicateur de charge coulométrique a une épaisseur inférieure à 0,020 pouces (environ 0,5 mm).

3. Pile électrochimique selon la revendication 2, dans laquelle le dispositif indicateur de charge coulométrique a une épaisseur inférieure à 0,005 pouces (environ 0,127 mm).

4. Pile électrochimique selon l'une quelconque des revendications 1 à 3, dans laquelle le segment résistif est d'environ 0,01 à 1000 ohms.

5. Pile électrochimique selon la revendication 1, dans laquelle le coulomètre comprend une première électrode (4), une seconde électrode (8) et un électrolyte (6) et dans laquelle la seconde électrode (8) est superposée à l'électrolyte (6) et à la première électrode (4).

6. Pile électrochimique selon la revendication 5, dans laquelle les première et seconde électrodes (4, 8) sont à une certaine distance dans le même plan et l'électrolyte (6) est disposé dans l'espace défini par la première électrode (4) et la seconde électrode (8).

7. Pile électrochimique selon la revendication 5 ou la revendication 6, dans laquelle l'électrolyte (6) présente une construction d'épaisseur variable (24).

8. Pile électrochimique selon la revendication 5 ou la revendication 6, dans laquelle l'électrolyte (6) présente une construction de forme échelonnée (34).

9. Pile électrochimique selon la revendication 7, dans laquelle l'épaisseur variable de l'électrolyte (6) est conçue de sorte qu'à la décharge, une empreinte prédéterminée est produite sur le dispositif indicateur de charge coulométrique (2).

10. Pile électrochimique selon la revendication 5, dans laquelle la première électrode (4) est gaufrée de façon à produire au moins une cavité de sorte que l'électrolyte (6) dans ladite au moins une cavité sera plus épais que l'électrolyte (6) disposé à proximité de la cavité afin que lors de la décharge, une empreinte prédéterminée soit produite sur le dispositif indicateur de charge coulométrique (2).

11. Pile électrochimique selon l'une quelconque des revendications 5 à 10, dans laquelle la première électrode (4) est sélectionnée parmi le cuivre, le nickel, l'argent, le bismuth, l'étain, le zinc et l'or et la seconde électrode (8) est sélectionnée parmi le cuivre, le nickel, l'argent, le bismuth, l'étain, le zinc et l'or.

12. Pile électrochimique selon l'une quelconque des revendications 5 à 11, dans laquelle l'électrolyte (6) est sélectionné dans le groupe constitué de polymères conducteurs ioniques, de matériaux inorganiques à l'état solide et de composites organiques-inorganiques.

13. Pile électrochimique selon l'une quelconque des revendications 5 à 12, dans laquelle la première électrode (4) est du cuivre, la seconde électrode (8) est du cuivre et l'électrolyte (6) est du poly(éthylène oxyde) contenant des ions cuivre.

14. Pile électrochimique selon l'une quelconque des revendications 5 à 12, dans laquelle la première électrode (4) est de l'argent, la seconde électrode (8) est de l'argent et l'électrolyte (6) comprend du nitrate d'argent.

15. Pile électrochimique selon l'une quelconque des revendications précédentes, dans laquelle un film plastique (10) est disposé sur le coulomètre (2) et dans laquelle ledit film plastique (10) assure la fonction d'étiquette de la pile.

16. Pile électrochimique selon l'une quelconque des revendications précédentes, dans laquelle une échelle indicatrice est utilisée avec le coulomètre (2) de façon à permettre l'observation de façon catégorique de la capacité résiduelle de la pile pendant la décharge de la pile.

17. Pile électrochimique logée dans un boîtier et comportant un dispositif indicateur de charge coulométrique (2), ledit dispositif indicateur de charge coulométrique (2) comprenant une première électrode (4) capable d'être dissoute de façon électrochimique, un électrolyte (6) disposé en contact avec ladite première électrode (4) et une seconde électrode (8) en contact avec ledit électrolyte (6) et capable de recevoir la première électrode dissoute (4); ledit dispositif indicateur de charge coulométrique (2) étant relié en parallèle d'un côté et de l'autre d'un trajet de circulation de courant d'un segment résistif de ladite pile de sorte que lorsque la pile se déchargera, un courant circulera à travers l'élément résistif en produisant ainsi une tension aux bornes du dispositif indicateur de charge coulométrique (2), si bien que ladite première électrode (4) se dissoudra et sera transportée à travers l'électrolyte (6) et déposée sur la seconde électrode (8), et dans laquelle la quantité de la première électrode (4) déposée sur la seconde électrode (8) peut être utilisée pour indiquer la capacité de la pile, **caractérisée en ce que** le dispositif indicateur est sous la forme d'une couche mince et est situé sur la pile.
